# EUROPÄISCHE PATENTSCHRIFT

(11) **EP 2 713 684 B1**
(45) Veröffentlichungstag und Bekanntmachung des Hinweises auf die Patenterteilung: **15.11.2017**
(21) Anmeldenummer: 13185673.4
(22) Anmeldetag: 24.09.2013
(51) Int. Cl.: H05K 3/34

(54) **Verfahren zum Herstellen einer Lötverbindung und Schaltungsbauteil**
Method for creating a soldered connection and circuit component
Procédé de fabrication d'une liaison soudée et composant de circuit

(30) Priorität: 01.10.2012 DE 102012217922
(43) Veröffentlichungstag der Anmeldung: 02.04.2014
(73) Patentinhaber: ROBERT BOSCH GMBH, 70442 Stuttgart (DE)
(72) Erfinder: Guyenot, Michael, 71638 Ludwigsburg (DE); Herberholz, Timo, 70188 Stuttgart (DE); Fix, Andreas, 70439 Stuttgart (DE)

(56) Entgegenhaltungen:
- CN-C- 100 452 372
- US-A1- 2010 096 043
- US-A1- 2012 103 678
- US-B1- 6 609 651

## Beschreibung

### Stand der Technik

Die Erfindung betrifft ein Verfahren zum Herstellen einer Lötverbindung nach dem Oberbegriff des Anspruchs 1. Ferner betrifft die Erfindung ein Schaltungsbauteil, das unter Verwendung eines erfindungsgemäßen Verfahrens hergestellt ist.

Ein Verfahren nach dem Oberbegriff des Anspruchs 1 ist aus der US 6,609,651 B1 bekannt. Bei dem bekannten Verfahren wird auf einen Schaltungsträger, der in Form einer Leiterplatte ausgebildet ist, im Bereich einer Durchkontaktierung für einen Befestigungspin eines elektronischen Bauteils ein aus mehreren Schichten bzw. Komponenten bestehender Lötverbund aufgebracht. Der Lötverbund besteht dabei insbesondere aus zumindest zwei Schichten aus unterschiedlichen Materialien, die verschiedene Schmelztemperaturen aufweisen. Bei einer Ausführungsform der Erfindung ist es vorgesehen, dass die Schichten jeweils Metallpartikel aufweisen. Zum Ausbilden der Lötverbindung wird die aus dem Schaltungsträger, den Schichten sowie dem elektronischen Bauteil bestehende Anordnung einer Wärmebehandlung ausgesetzt, bei der das Material der Schicht, die einen niedrigeren Schmelzpunkt aufweist verflüssigt wird und in Verbindung mit dem Material der den höheren Schmelzpunkt aufweisenden Schicht gelangt. Nach dem Erstarren des Bauteileverbunds weist eine derartige Lötverbindung eine Aufschmelztemperatur auf, die höher ist als die Schmelztemperatur der die niedrigere Schmelztemperatur aufweisenden Schicht. Ein derartiges Verfahren eignet sich insbesondere für die Verwendung von bleifreien Lotmitteln. Nachteilig dabei ist, dass das Aufbringen der einzelnen Schichten relativ aufwändig ist, insbesondere, wenn eine Vielzahl von ersten und zweiten Schichten vorgesehen ist.

Aus der US 2012/103678A1 ist ein Verfahren zum Herstellen einer Lötverbindung bekannt, bei dem in einem ersten Schritt eine Metallpartikel enthaltende erste Schicht auf einen Schaltungsträger aufgebracht wird. Diese erste Schicht wird anschließend einer Wärmebehandlung unterzogen, bei der die Metallpartikel versintern. Anschließend erfolgt das Aufbringen einer Lotschicht auf die versinterte erste Schicht und eines elektronischen Bauteils auf die Lotschicht. Anschließend erfolgt durch eine weitere Wärmebehandlung ein Verflüssigen der Lotschicht, bei der das Lot in die erste, metallische Schicht eindringt und gleichzeitig die Lötverbindung zum elektronischen Bauteil ausbildet.

Aus der CN 100 452 372 C ist darüber hinaus ein Verfahren zum Ausbilden einer Lötverbindung bekannt, bei der ein elektronisches Bauteil in Form eines Chips mit zwei metallischen Schichten beschichtet wird. Nach Durchführen einer ersten Wärmebehandlung bildet sich zwischen den beiden metallischen Schichten eine Zwischenlegierungsschicht aus. Der so vorbereitete Verbund wird anschließend mit einem Schaltungsträger verbunden, auf dem bereits eine Lotschicht aufgebracht wurde. Das Ausbilden der Lötverbindung zwischen dem Schaltungsträger und dem elektronischen Bauteil erfolgt anschließend durch eine weitere, zweite Wärmebehandlung, bei der das Lot der Lotschicht verflüssigt wird und in Wirkverbindung mit den metallischen Schichten gelangt.

### Offenbarung der Erfindung

Ausgehend von dem dargestellten Stand der Technik liegt der Erfindung die Aufgabe zugrunde, ein Verfahren zum Herstellen einer Lötverbindung nach dem Oberbegriff des Anspruchs 1 derart weiterzubilden, dass ein fertigungstechnisch besonders einfach realisierbares Verfahren ermöglicht wird. Diese Aufgabe wird erfindungsgemäß bei einem Verfahren zum Herstellen einer Lötverbindung mit den Merkmalen des Anspruchs 1 dadurch gelöst, dass in einem ersten Schritt zunächst die die Metallpartikel enthaltende erste Komponente bzw. Schicht auf dem Schaltungsträger aufgebracht wird, dass in einem zweiten Schritt das Bauteil in Wirkverbindung mit der ersten Komponente angeordnet wird, dass in einem dritten Schritt eine Wärmebehandlung der ersten Komponente erfolgt, bei der das Material der ersten Komponente zur Bildung einer Metallgitterstruktur mit Hohlräumen versintert, und dass in einem vierten Schritt die zweite Komponente mit dem Lotmittel im Verbindungsbereich der ersten Komponente mit dem Bauteil in Wirkverbindung mit der ersten Komponente gebracht wird. Im Gegensatz zum Stand der Technik wird es dadurch ermöglicht, dass zunächst nur eine einzige Komponente aufgebracht wird, die anschließend mit dem Bauteil verbunden wird. Diese Komponente enthält Metallpartikel, die beim Durchführen einer Wärmebehandlung versintern und eine Verbindung mit dem Bauteil herstellen, wobei der aus Schaltungsträger, ersten Komponente und Bauteil bestehende Verbund bewegt werden kann, ohne dass die Position des Bauteils auf dem Schaltungsträger sich verändert. Insbesondere wird dadurch auch ein "Aufschwimmen" des Bauteils verhindert, das entstehen kann, wenn das Bauteil auf einer eine relativ niedrigere Schmelztemperatur aufweisenden Lotschicht angeordnet wird, wie dies beim Stand der Technik auftreten würde, wenn anstelle eines Befestigungspins das Bauteil flächig auf die Komponenten aufgelegt werden würde.

Vorteilhafte Weiterbildungen des erfindungsgemäßen Verfahrens zum Herstellen einer Lötverbindung sind in den Unteransprüchen aufgeführt.

Besonders bevorzugt ist es, wenn die erste Komponente auf den Schaltungsträger aufgedruckt wird. Dadurch lässt sich auf relativ einfache Art und Weise eine konstante Dicke der Komponente bzw. Schicht erzielen, und es können auf einem Schaltungsträger in einem Fertigungsschritt eine Vielzahl von Kontaktbereichen für die Bauteile ausgebildet werden. Das Aufdrucken kann dabei, in an sich bekannter Art und Weise, entweder über ein Sieb- oder ein Schablonendruckverfahren erfolgen.

Besonders bevorzugt ist es weiterhin, wenn durch die entsprechenden Parameter (z.B. Menge und Anordnung der zweiten Komponente, Temperatur sowie Prozessdauer) es vorgesehen ist, dass das Material der zweiten Komponente zumindest die an der Oberfläche der Metallgitterstruktur der ersten Komponente ausgebildeten Hohlräume auffüllt. Dadurch werden eine porenfreie bzw. glatte Oberfläche sowie eine hohe Lötqualität erzielt.

Fertigungstechnisch besonders einfach lässt sich die zweite Komponente in Wirkverbindung mit der ersten Komponente bringen, wenn die zweite Komponente in Form einer Lötwelle in Kontakt mit der ersten Komponente gebracht wird. Ein derartiges Vorgehen hat darüber hinaus den Vorteil, dass konventionelle Lötanlagen verwendet werden können. Dadurch werden insbesondere zusätzliche Investitionen nicht erforderlich, und eine bereits vorhandene Lötanlage sowohl für das erfindungsgemäße Verfahren, als auch für ein konventionelles Lötverfahren verwendet werden kann.

Als geeignete Metallpartikel für die erste Komponente haben sich Partikel aus Kupfer, Bronze, Nickel, Zink, Messing o.ä. herausgestellt, wobei die Partikelgröße zwischen 1µm und 50µm beträgt. Weiterhin ist es vorgesehen, dass die erste Komponente neben den Metallpartikeln in Form einer Paste ausgebildet ist. Dadurch lässt sich die erste Komponente sowohl während der Wärmebehandlung der ersten Komponente, als auch bei dem anschließenden Lötprozess, bei dem die zweite Komponente in Wirkverbindung mit der ersten Komponente gelangt, optimal verarbeiten.

Bei einer ersten konkreten Ausgestaltung des erfindungsgemäßen Verfahrens wird es vorgeschlagen, dass die erste Komponente und das Bauteil auf einer Oberseite des Schaltungsträgers aufgebracht bzw. angeordnet werden, und dass der Schaltungsträger zum in Kontakt bringen mit der Lötwelle gedreht wird, so dass das Bauteil nach unten ragt. Ein derartiges Verfahren hat den Vorteil, dass der Schaltungsträger relativ einfach aufgebaut werden kann, da beispielsweise keine Durchkontaktierungen vorgesehen werden müssen. Darüber hinaus eignet sich dieses Verfahren insbesondere für SMD-Bauteile, die keine Anschlusspins aufweisen.

In einer alternativen Ausgestaltung der Erfindung ist es vorgesehen, dass in dem Schaltungsträger in Überdeckung mit dem Bauteil wenigstens eine Durchkontaktierung ausgebildet ist, und dass die Lötwelle (zweite Komponente) in die wenigstens eine Durchkontaktierung aufsteigt und dabei in Wirkverbindung mit der ersten Komponente auf der dem Bauteil zugewandten Seite gelangt. Ein derartiges Verfahren eignet sich insbesondere für flächige SMD-Bauteile, bei dem vermieden werden soll, dass die Bauteile in unmittelbarem Kontakt mit der zweiten Komponente gelangen.

In wiederum alternativer Ausgestaltung, die zur Verwendung bei Teilen mit Anschlusspins besonders geeignet ist, wird vorgeschlagen, dass in dem Schaltungsträger in Überdeckung mit dem Bauteil wenigstens eine Durchkontaktierung ausgebildet ist, dass das Material der ersten Komponente in die Durchkontaktierung zumindest teilweise hineinragt, dass das Bauteil einen in die Durchkontaktierung hineinragenden Anschlusspin aufweist, und dass die Lötwelle (zweiten Komponente) auf der dem Bauteil abgewandten Seite des Schaltungsträgers im Bereich der Durchkontaktierung in Wirkverbindung mit dem Material der ersten Komponente gelangt.

Die Erfindung umfasst auch ein Schaltungsbauteil, mit insbesondere einem als Leiterplatte ausgebildeten Schaltungsträger, auf dem elektronische Bauteile angeordnet sind, wobei das Schaltungsbauteil nach einem erfindungsgemäßen Verfahren hergestellt ist. Anstelle einer Leiterplatte liegt es jedoch auch im Rahmen der Erfindung, den Schaltungsträger als (keramisches) Substrat oder als (Kupfer-)Stanzgitter auszubilden.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1 bis 4: eine erste Ausführungsform eines erfindungsgemäßen Verfahrens zum Herstellen einer Lötverbindung während unterschiedlicher Prozessschritte,
- Fig. 5 bis 8: ein zweite Ausführungsform des erfindungsgemäßes Verfahren, bei der ein flächiges Bauelement mit einem Durchkontaktierungen enthaltenden Schaltungsträger verbunden wird, ebenfalls während verschiedener Prozessschritte und
- Fig. 9 bis 12: ein gegenüber den Fig. 5 bis 8 abgewandeltes Verfahren, bei dem das Bauelement Anschlusspins aufweist.

Gleiche Elemente bzw. Elemente mit gleicher Funktion sind in den Figuren mit den gleichen Bezugsziffern versehen.

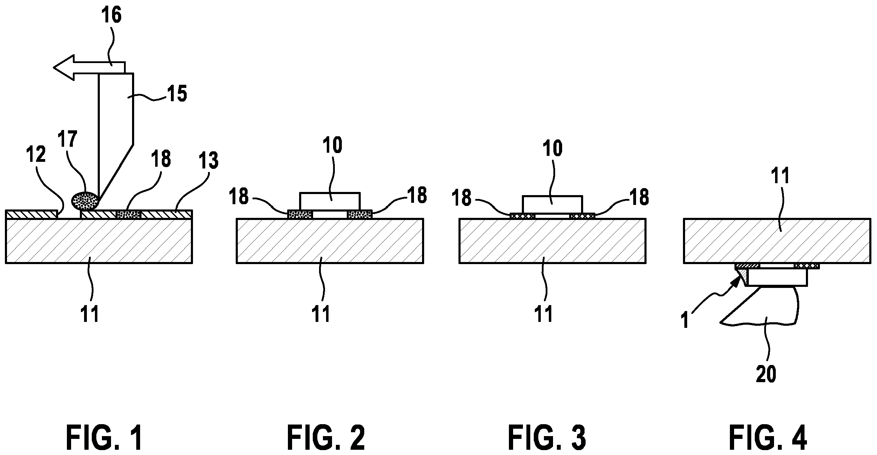

In den Fig. 1 bis 4 ist ein erstes erfindungsgemäßes Verfahren zum Herstellen einer Lötverbindung 1 zwischen einem Bauteil 10 und einem Schaltungsträger 11 dargestellt. Bei dem Schaltungsträger 11 handelt es sich insbesondere um eine bedruckte Leiterplatte (PCB) mit elektrisch leitenden Bereichen, an denen eine elektrische Kontaktierung des Bauteils 10 über die Lötverbindungen 1 stattfindet. Hierbei wird erwähnt, dass in den Figuren die elektrisch leitenden Bereiche des Schaltungsträgers 11 aus Vereinfachungsgründen nicht dargestellt sind.

Bei dem Bauteil 10 handelt es sich insbesondere um ein SMD-Bauteil 10. Ein derartiger, mit Bauteilen 10 ausgebildeter Schaltungsträger 11 bildet im fertigen Zustand ein Schaltungsbauteil aus, das beispielsweise Bestandteil eines elektronischen Steuergeräts in einem Kraftfahrzeug ist.

Zur Herstellung der Lötverbindung 1 zwischen dem Bauteil 10 und dem Schaltungsträger 11 wird entsprechend der Fig. 1 in einem ersten Schritt auf die Oberseite bzw. Oberfläche des Schaltungsträgers 11 eine Öffnungen 12 aufweisende Schablone 13 aufgesetzt und anschließend mittels eines Rakels 15, der in Richtung des Pfeils 16 bewegt wird, das Material einer Paste 17 in die Öffnungen 12 eingebracht. Dadurch wird in Abhängigkeit von der Dicke der Schablone 13 auf dem Schaltungsträger 11 in den Bereichen, in denen eine elektrisch leitende Verbindung mit dem Bauteil 10 hergestellt werden soll, eine erste Komponente in Form einer ersten Schicht 18 erzeugt bzw. aufgebracht. Bei dem Material für die erste Schicht 18 bzw. der Paste 17 handelt es sich um eine Paste 17, die Metallpartikel und vorzugsweise Flussmittel enthält. Bei den Metallpartikeln handelt es sich insbesondere um Partikel aus Kupfer, Bronze, Nickel, Zink, Messing o.ä. sowie Partikelmischungen aus den genannten Materialien mit einer Partikelgröße zwischen 1µm und 50µm. Die Schichtdicke der (zunächst noch nassen) ersten Schicht 18 beträgt bevorzugt etwa zwischen 10µm und 100µm.

Nach dem Aufbringen bzw. Aufdrucken der ersten Schicht 18 auf die Oberfläche des Schaltungsträgers 11 wird entsprechend der Darstellung der Fig. 2 nach dem Entfernen der Schablone 13 das Bauteil 10 auf die erste Schicht 18 aufgesetzt. Im dargestellten Ausführungsbeispiel weist das Bauteil 10 zwei Kontaktstellen auf, an denen das Bauteil 10 auf der ersten Schicht 18 aufliegt.

In einem dritten Schritt wird der aus Schaltungsträger 11, Bauteil 10 und erster Komponente bzw. Schicht 18 bestehende Verbund einer Wärmebehandlung unterzogen, die in der Fig. 3 symbolisch dargestellt sein soll. Dabei wird zumindest die erste Schicht 18 bis auf eine Temperatur von beispielsweise 220°C erhitzt, wobei die Temperatur je nach Anwendungsfall auch bis zu 280°C betragen kann. Bei der Erwärmung der ersten Schicht 18 versintern die Metallpartikel der ersten Schicht 18 unter Bildung einer Metallgitterstruktur, wobei die Metallgitterstruktur Hohlräume bzw. Poren aufweist. Gleichzeitig findet ein Schrumpfen der ersten Schicht 18 statt, was anhand der verringerten Schichtdicke der ersten Schicht 18 in der Fig. 3 im Vergleich zur Fig. 2 verdeutlicht sein soll.

In einem vierten Prozessschritt wird anschließend entsprechend der Darstellung der Fig. 4 der Schaltungsträger 11 gedreht, so dass das Bauteil 10 nach unten ragt. Durch den vorher stattgefundenen Versinterungsprozess der ersten Schicht 18 haftet dabei das Bauteil 10 an der ersten Schicht 18 an, sodass ein Abfallen des Bauteils 10 von dem Schaltungsträger 11 ausgeschlossen ist. Anschließend gelangt eine zweite Komponente in Form einer Lötwelle 20, die ein vorzugsweise bleifreies Lot enthält, wobei der Schmelzpunkt des Materials der Lötwelle 20 unterhalb des Schmelzpunkts der ersten Schicht 18 liegt, in Wirkverbindung mit der ersten Schicht 18 und bildet die endgültige Lötverbindung 1 aus. Dabei beträgt die typische Löttemperatur beispielsweise etwa 220°C bis 230°C. Sie kann jedoch, je nach Anwendungsfall, in einem Bereich zwischen 180°C bis 250°C liegen. Beim Kontakt der zweiten Komponente bzw. Lötwelle 20 mit der ersten Schicht 18 gelangt das verflüssigte Lot der Lötwelle 20 zumindest in die an der Oberfläche der ersten Schicht 18 ausgebildeten Poren der Metallgitterstruktur der ersten Schicht 18 und verschließt diese, so dass die Lötverbindung 18 eine porenfreie bzw. glatte Oberfläche aufweist.

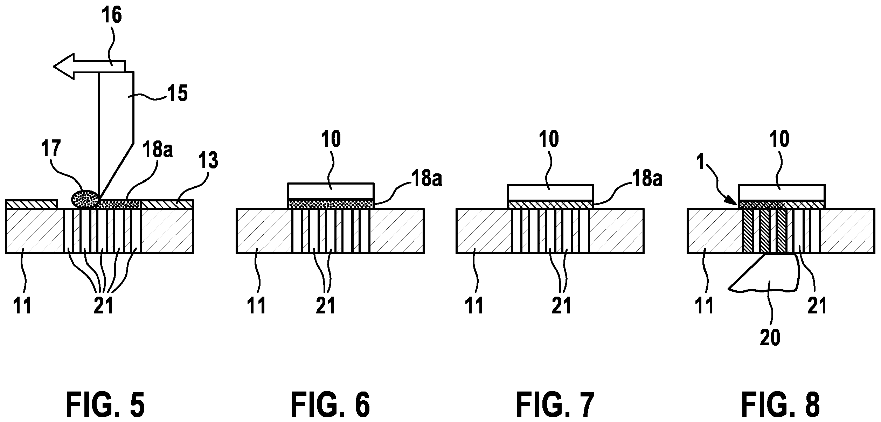

In den Fig. 5 bis 8 ist ein zweites erfindungsgemäßes Verfahren dargestellt. Hierbei weist der Schaltungsträger 11 in der Zeichnungsebene der Figuren beispielhaft fünf nebeneinander angeordnete Durchkontaktierungen 21 auf, die im Ausführungsbeispiel jeweils gleich ausgebildet sind. In Analogie zum ersten Ausführungsbeispiel wird gemäß der Fig. 5 in einem ersten Prozessschritt die erste Komponente bzw. Schicht 18a auf die Oberseite bzw. Oberfläche des Schaltungsträgers 11a aufgebracht. Dabei findet das Aufbringen der ersten Schicht 18a in Überdeckung mit den Durchkontaktierungen 21 statt.

Anschließend wird entsprechend der Fig. 6 in einem zweiten Prozessschritt das flächige (SMD-)Bauteil 10 auf die erste Schicht 18a aufgebracht. Nach dem in der Fig. 7 dargestellten dritten Prozessschritt der Wärmebehandlung, bei der die erste Schicht 18a in Analogie zur ersten Schicht 18 versintert und eine Metallgitterstruktur ausbildet, wird anschließend in einem vierten Prozessschritt entsprechend der Fig. 8 eine Lötwelle auf der dem Bauteil 10 gegenüberliegenden Seite des Schaltungsträgers 11a in Wirkverbindung mit dem Schaltungsträger 11a gebracht, wobei das Material der Komponente bzw. Lötwelle 20 in die Durchkontaktierungen 21 gelangt, und dort bis in den Bereich der ersten Schicht 18a aufsteigt und sich mit diesem verbindet bzw. die dort vorhandenen Hohlräume der Metallgitterstruktur auffüllt.

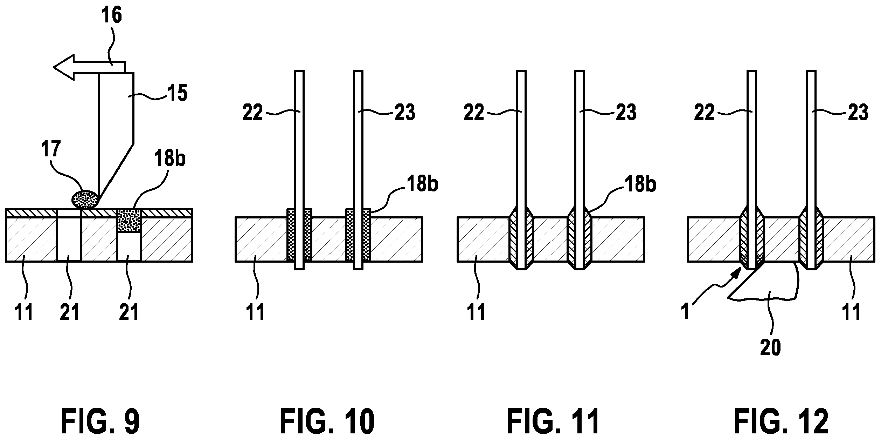

Zuletzt ist in den Fig. 9 bis 12 ein drittes Ausführungsbeispiel der Erfindung dargestellt, das sich von dem Ausführungsbeispiel gemäß den Fig. 5 bis 8 dadurch unterscheidet, dass das Bauteil 10 in der Zeichnungsebene der Figuren beispielhaft zwei Anschlusspins 22, 23 aufweist, die in die Durchkontaktierungen 21 eingesteckt werden und diese vollständig durchdringen. Zuvor wurde entsprechend der Fig. 9 die erste Schicht 18b im Bereich der Durchkontaktierungen 21 angeordnet, wobei das Material der ersten Schicht 18b zumindest teilweise in die Durchkontaktierungen 21 hineinragt. Vorzugsweise ist es vorgesehen, dass soviel Material der ersten Schicht 18b in den Bereich der Durchkontaktierungen 21 gelangt, dass nach dem Durchstecken der Anschlusspins 22, 23 entsprechend der Fig. 10 das Material der ersten Komponente bzw. Schicht 18b die Durchkontaktierungen 21 vollständig ausfüllt. Anschließend findet entsprechend der Fig. 11 wiederum eine Wärmebehandlung statt, bei der das Material der ersten Schicht 18b versintert. Zuletzt wird entsprechend der Fig. 12 über die Unterseite des Schaltungsträgers 11a eine zweite Komponente bzw. Lötwelle 20 bewegt, die in Wirkverbindung mit der ersten Schicht 18b gelangt und deren Poren zumindest an der Oberfläche verschließt und die Lötverbindungen 1 ausbildet.

## Patentansprüche

1. Verfahren zum Herstellen einer Lötverbindung (1), bei dem ein elektronisches Bauteil (10) mit einem Schaltungsträger (11) verbunden wird, wobei die Lötverbindung (1) aus zwei unterschiedliche Schmelzpunkte aufweisenden Komponenten (18; 18a; 18b, 20) besteht, wobei eine erste Komponente (18; 18a; 18b) zumindest Metallpartikel und eine zweite Komponente (20) zumindest ein Lotmittel enthält,
**dadurch gekennzeichnet,**
**dass** in einem ersten Schritt zunächst die die Metallpartikel enthaltende erste Komponente (18; 18a; 18b) auf den Schaltungsträger (11) aufgebracht wird, dass nach dem ersten Schritt in einem zweiten Schritt das Bauteil (10) in Wirkverbindung mit der ersten Komponente (18; 18a; 18b) angeordnet wird, dass in einem dritten Schritt eine Wärmebehandlung der ersten Komponente (18; 18a; 18b) erfolgt, durch die das Material der ersten Komponente (18; 18a; 18b) unter Bildung einer Metallgitterstruktur mit Hohlräumen versintert, und dass anschließend an den dritten Schritt in einem vierten Schritt die zweite Komponente (20) mit dem Lotmittel im Verbindungsbereich der ersten Komponente (18; 18a; 18b) mit dem Bauteil (10) in Wirkverbindung mit der ersten Komponente (18; 18a; 18b) gebracht wird.

2. Verfahren nach Anspruch 1,
**dadurch gekennzeichnet,**
**dass** die erste Komponente (18; 18a; 18b) auf den Schaltungsträger (11) aufgedruckt wird.

3. Verfahren nach Anspruch 1 oder 2,
**dadurch gekennzeichnet,**
**dass** das Material der zweiten Komponente (20) zumindest die an der Oberfläche der Metallgitterstruktur der ersten Komponente (18; 18a; 18b) ausgebildeten Hohlräume auffüllt.

4. Verfahren nach einem der Ansprüche 1 bis 3,
**dadurch gekennzeichnet,**
**dass** die zweite Komponente (20) in Form einer Lötwelle in Wirkverbindung mit der ersten Komponente (18; 18a; 18b) gebracht wird.

5. Verfahren nach einem der Ansprüche 1 bis 4,
**dadurch gekennzeichnet,**
**dass** als Metallpartikel für die erste Komponente (18; 18a; 18b) Partikel aus Kupfer, Bronze, Nickel, Zink, Messing mit einer Partikelgröße zwischen 1µm und 50µm oder Partikelmischungen aus den genannten Materialien verwendet werden, und dass die erste Komponente (18; 18a; 18b) in Form einer Paste ausgebildet ist.

6. Verfahren nach einem der Ansprüche 1 bis 5,
**dadurch gekennzeichnet,**
**dass** die Temperatur beim Versintern der ersten Komponente (18; 18a; 18b) zwischen 220°C und 280°C beträgt, und dass die Temperatur der zweiten Komponente (20) beim Verbinden mit der ersten Komponente (18; 18a; 18b) zwischen 180°C bis 250°C beträgt.

7. Verfahren nach einem der Ansprüche 4 bis 6,
**dadurch gekennzeichnet,**
**dass** die erste Komponente (18) und das Bauteil (10) auf einer Oberseite des Schaltungsträgers (11) aufgebracht bzw. angeordnet werden, und dass der Schaltungsträger (11) zum in Kontakt bringen mit der Lötwelle gedreht wird, so dass das Bauteil (10) zur Lötwelle hin nach unten ragt.

8. Verfahren nach einem der Ansprüche 4 bis 6,
**dadurch gekennzeichnet,**
**dass** in dem Schaltungsträger (11) in Überdeckung mit dem Bauteil (10) wenigstens eine Durchkontaktierung (21) ausgebildet ist, und dass die Lötwelle in der wenigstens einen Durchkontaktierung (21) aufsteigt und dabei in Wirkverbindung mit der ersten Komponente (18a) auf der dem Bauteil (10) zugewandten Seite gelangt.

9. Verfahren nach einem der Ansprüche 4 bis 6,
**dadurch gekennzeichnet,**
**dass** in dem Schaltungsträger (11) in Überdeckung mit dem Bauteil (10) wenigstens eine Durchkontaktierung (21) ausgebildet ist, dass das Material der ersten Komponente (18b) in die Durchkontaktierung (21) zumindest teilweise hineinragt, dass das Bauteil (10) einen in die Durchkontaktierung (21) hineinragenden Anschlusspin (22, 23) aufweist, und dass die Lötwelle auf der dem Bauteil (10) abgewandten Seite des Schaltungsträgers (11) im Bereich der Durchkontaktierung (21) in Wirkverbindung mit dem Material der ersten Komponente (18b) gelangt.

## Claims

1. Method for creating a soldered connection (1), in which an electronic component (10) is connected to a circuit carrier (11), the soldered connection (1) consisting of two components (18; 18a; 18b, 20) having different melting points, a first component (18; 18a; 18b) containing at least metal particles and a second component (20) containing at least a soldering agent,
**characterized**
**in that**, in a first step, first the first component (18; 18a; 18b), containing the metal particles, is applied to the circuit carrier (11), in that, after the first step, in a second step, the component (10) is arranged in operative connection with the first component (18; 18a; 18b), and in that, in a third step, a heat treatment of the first component (18; 18a; 18b) is performed, by which the material of the first component (18; 18a; 18b) sinters to form a metal grid structure with cavities, and in that, following the third step, in a fourth step, the second component (20) with the soldering agent is brought into operative connection with the first component (18; 18a; 18b) in the connecting region of the first component (18; 18a; 18b) to the component (10).

2. Method according to Claim 1,
**characterized**
**in that** the first component (18; 18a; 18b) is printed onto the circuit carrier (11).

3. Method according to Claim 1 or 2,
**characterized**
**in that** the material of the second component (20) fills at least the cavities formed at the surface of the metal grid structure of the first component (18; 18a; 18b).

4. Method according to one of Claims 1 to 3,
**characterized**
**in that** the second component (20) in the form of a solder wave is brought into operative connection with the first component (18; 18a; 18b).

5. The method according to one of Claims 1 to 4,
**characterized**
**in that** particles of copper, bronze, nickel, zinc or brass with a particle size of between 1 µm and 50 µm or mixtures of particle of the stated materials are used as metal particles for the first component (18; 18a; 18b), and in that the first component (18; 18a; 18b) takes the form of a paste.

6. Method according to one of Claims 1 to 5,
**characterized**
**in that** the temperature during the sintering of the first component (18; 18a; 18b) is between 220°C and 280°C, and in that the temperature of the second component (20) during the connection to the first component (18; 18a; 18b) is between 180°C and 250°C.

7. Method according to one of Claims 4 to 6,
**characterized**
**in that** the first component (18) and the component (10) are applied or arranged on an upper side of the circuit carrier (11), and in that the circuit carrier (11) is turned for bringing into contact with the solder wave, so that the component (10) extends downwardly towards the solder wave.

8. Method according to one of Claims 4 to 6,
**characterized**
**in that** at least one via hole (21) is formed in the circuit carrier (11) congruent with the component (10), and in that the solder wave rises up in the at least one via hole (21) and thereby enters into operative connection with the first component (18a) on the side that is facing the component (10).

9. Method according to one of Claims 4 to 6,
**characterized**
**in that** at least one via hole (21) is formed in the circuit carrier (11) congruent with the component (10), in that the material of the first component (18b) extends at least partially into the via hole (21), in that the component (10) has a terminal pin (22, 23) extending into the via hole (21), and in that the solder wave enters into operative connection with the material of the first component (18b) in the region of the via hole (21) on the side of the circuit carrier (11) that is facing away from the component (10).

## Revendications

1. Procédé destiné à la production d'une liaison par brasage (1), pour lequel un élément de structure (10) électronique est relié à un support de circuit (11) ;
selon lequel la liaison par brasage (1) est constituée de deux composants (18 ; 18a ; 18b, 20) qui présentent des points de fusion différents ;
selon lequel un premier composant (18 ; 18a ; 18b) contient tout au moins des particules métalliques et un deuxième composant (20) contient tout au moins un agent à braser ;
**caractérisé en ce que**
le premier composant (18 ; 18a ; 18b) contenant les particules métalliques est tout d'abord appliqué sur le support de circuit (11), durant une première phase ; **caractérisé en ce que**
à l'issue de la première phase, l'élément de structure (10) est disposé en liaison active avec le premier composant (18 ; 18a ; 18b), durant une deuxième phase ;
**caractérisé en ce que**
un traitement thermique du premier composant (18 ; 18a ; 18b) est réalisé, par l'intermédiaire duquel le matériau du premier composant (18 ; 18a ; 18b) est fritté en donnant lieu à une structure en grille métallique avec des cavités, durant une troisième phase ; et
**caractérisé en ce que**
faisant suite à la troisième phase, le deuxième composant (20) est amené en liaison active avec le premier composant (18 ; 18a ; 18b), avec l'agent à braser dans une zone de liaison du premier composant (18 ; 18a ; 18b) avec l'élément de structure (10), durant une quatrième phase.

2. Procédé selon la revendication 1,
**caractérisé en ce que**
le premier composant (18 ; 18a ; 18b) est imprimé sur le support de circuit (11).

3. Procédé selon la revendication 1 ou 2,
**caractérisé en ce que**
le matériau du deuxième composant (20) remplit tout au moins les cavités conçues au niveau de la surface de la structure en grille métallique du premier composant (18 ; 18a ; 18b).

4. Procédé selon l'une des revendications 1 à 3,
**caractérisé en ce que**
le deuxième composant (20) est amené en liaison active avec le premier composant (18 ; 18a ; 18b) sous la forme d'un passage de brasage.

5. Procédé selon l'une des revendications 1 à 4,
**caractérisé en ce que**
des particules en cuivre, en bronze, en nickel, en zinc et en laiton, dont la taille particulaire est comprise entre 1 µm et 50 µm, ou des mélanges de particules issus des matériaux mentionnés sont utilisés comme particules métalliques pour le premier composant (18 ; 18a ; 18b) ; et
**caractérisé en ce que**
le premier composant (18 ; 18a ; 18b) se présente sous la forme d'une pâte.

6. Procédé selon l'une des revendications 1 à 5,
**caractérisé en ce que**
la température pendant le frittage du premier composant (18 ; 18a ; 18b) est comprise entre 220 °C et 280 °C ; et
**caractérisé en ce que**
la température du deuxième composant (20) lors de la liaison avec le premier composant (18 ; 18a ; 18b) est comprise entre 180 °C et 250 °C.

7. Procédé selon l'une des revendications 4 à 6,
**caractérisé en ce que**
le premier composant (18) et l'élément de structure (10) sont appliqués, respectivement disposés sur une face supérieure du support de circuit (11) ; et
**caractérisé en ce que**
le support de circuit (11) est orienté de telle sorte, en vue de la mise en contact avec le passage de brasage, que l'élément de structure (10) fait saillie vers le bas en direction du passage de brasage.

8. Procédé selon l'une des revendications 4 à 6,
**caractérisé en ce que**
tout au moins un via (21) est conçu dans le support de circuit (11), en coïncidence avec l'élément de structure (10) ; et
**caractérisé en ce que**
le passage de brasage remonte dans le tout au moins un via (21) et parvient à cette occasion sur la face qui est tournée vers l'élément de structure (10), en liaison active avec le premier composant (18a).

9. Procédé selon l'une des revendications 4 à 6,
**caractérisé en ce que**
tout au moins un via (21) est conçu dans le support de circuit (11), en coïncidence avec l'élément de structure (10) ;
**caractérisé en ce que**
le matériau du premier composant (18b) pénètre dans le via (21), tout au moins en partie ;
**caractérisé en ce que**
l'élément de structure (10) présente une broche de raccordement (22, 23) qui pénètre dans le via (21) ; et
**caractérisé en ce que**
le passage de brasage parvient sur la face du support de circuit (11) qui se trouve à l'opposé de l'élément de structure (10) dans la zone du via (21), en liaison active avec le matériau du premier composant (18b).
